Europäisches Patentamt

European Patent Office

Office européen des brevets

(19)

(11) Veröffentlichungsnummer: **0 373 436**
**A2**

(12) **EUROPÄISCHE PATENTANMELDUNG**

(21) Anmeldenummer: 89122175.6

(22) Anmeldetag: 01.12.89

(51) Int. Cl.⁵: **G03F 7/033**

(30) Priorität: 16.12.88 DE 3842448

(43) Veröffentlichungstag der Anmeldung:
20.06.90 Patentblatt 90/25

(84) Benannte Vertragsstaaten:
**BE CH DE FR GB IT LI NL**

(71) Anmelder: **BASF Aktiengesellschaft**
**Carl-Bosch-Strasse 38**
**D-6700 Ludwigshafen(DE)**

(72) Erfinder: **Bauer, Gerhard, Dr.**
**Uhlandstrasse 16**
**D-6940 Weinheim(DE)**
Erfinder: **Hoffmann, Gerhard, Dr.**
**Pappelstrasse 22**
**D-6701 Otterstadt(DE)**
Erfinder: **Sanner, Axel, Dr.**
**Lorscher Ring 2 c**
**D-6710 Frankenthal(DE)**
Erfinder: **Seitz, Friedrich, Dr.**
**Von-Wieser-Strasse 1**
**D-6701 Friedelsheim(DE)**

(54) **Lichtempfindliches Aufzeichnungselement.**

(57) Die Erfindung betrifft ein lichtempfindliches, zur Herstellung von Druckformen oder Resistmustern geeignetes Aufzeichnungselement mit einer auf einem dimensionsstabilen Träger aufgebrachten, wäßrig-alkalisch entwickelbaren, ein polymeres Bindemittel, mindestens eine ethylenisch ungesättigte, photopolymerisierbare Verbindung, mindestens einen Photoinitiator sowie gegebenenfalls weitere Zusatz- und/oder Hilfsstoffe enthaltenden, photopolymerisierbaren Aufzeichnungsschicht, wobei in der photopolymerisierbaren Aufzeichnungsschicht ein Zusatz eines N-Vinylamid-Homopolymerisats, eines N-Vinyllactam-Copolymerisats oder eines Polyamids vorhanden ist.

Dieses lichtempfindliche Aufzeichnungselement eignet sich besonders als Trockenresist.

EP 0 373 436 A2

## Lichtempfindliches Aufzeichnungselement

Die Erfindung betrifft ein lichtempfindliches Aufzeichnungselement, insbesondere einen Trokkenfilmresist, mit einer auf einem dimenionsstabilen, temporären Träger, aufgebrachten festen, wäßrig-alkalisch entwickelbaren photopolymerisierbaren Resistschicht sowie gegebenenfalls einer abziehbaren Deckfolie auf dieser Resistschicht. Die Erfindung betrifft des weiteren ein Verfahren zur Herstellung von Resistmustern auf einem Substrat, bei dem auf das Substrat eine photopolymerisierbare, in wäßrig-alkalischen Entwicklermedien lösliche oder dispergierbare Resistschicht aufgebracht wird, diese Resistschicht bildmäßig mit aktinischem Licht belichtet wird und anschließend die nicht belichteten Bereiche der Resistschicht mit dem Entwicklermedium ausgewaschen werden.

Trockenfilmresists der in Rede stehenden Art sind bekannt und finden breite Anwendung zur Herstellung von Resistmustern in der Ätz- oder Galvano-Technik, bei der Herstellung von Leiterplatten sowie von Dünnschicht- und Mehrschichtschaltungen. Dabei gewinnen die wäßrig-alkalisch entwickelbaren Photoresist wegen ihrer umweltfreundlicheren Verarbeitbarkeit im Vergleich zu den mit organischen Lösungsmitteln entwickelbaren Resists immer stärker an Bedeutung. Die photopolymerisierbare Resistschicht besteht dabei im allgemeinen aus einer Mischung von mindestens einem in wäßrig-alkalischen Medien löslichen bzw. dispergierbaren polymeren Bindemittel, mindestens einer ethylenisch ungesättigten photopolymerisierbaren niedermolekularen Verbindung, mindestens einem Photoinitiator sowie gegebenenfalls weiteren Zusatz- und/oder Hilfsstoffen.

Als polymere Bindemittel für die wäßrig entwikkelbaren Resistschichten sind insbesondere Carboxyl-Gruppen oder Carbonsäureanhydrid-Gruppen enthaltende Polymere vorgeschlagen worden, wie z.B. Alkyl-(meth)acrylat/(Meth)acrylsäure-Copolymerisate, Styrol/Maleinsäureanhydrid-Copolymerisate, Styrol/Maleinsäurehalbester-Copolymerisate oder auch Styrol/Alkyl-(meth)acrylat/(Meth)acrylsäure-Copolymerisate (vgl. u.a. DE-B-20 64 080, DE-A-22 05 146 und EP-A-49 504) sowie gegebenenfalls Polymere aus anderen Comonomeren (vgl. u.a. DE-B-2 027 467, SU-PS 190 211, DE-A-2 205 146 oder DE-A-2 736 058). Als photopolymerisierbare niedermolekulare Verbindungen für diese Resistschichten sind verschiedenartige Acrylat- und Methacrylat-Verbindungen beschrieben, wobei die photopolymerisierbaren Resistschichten üblicherweise 40 bis 90 Gew.% der polymeren Bindemittel und 10 bis 60 Gew.% der photopolymerisierbaren niedermolekularen Verbindungen enthalten.

Ferner ist es bereits bekannt, zur Herstellung von photopolymeren Druck- oder Reliefformen photopolymerisierbare Gemische einzusetzen, die neben photopolymerisierbaren Monomeren, mindestens einem Photoinitiator sowie gegebenenfalls weiteren Zusatz- und/oder Hilfsstoffen als polymere Bindemittel Vinylpyrrolidon-Polymerisate, wie z.B. Polyvinylpyrrolidon oder Vinylpyrrolidon/Vinylacetat-Copolymerisate, enthalten (vgl. z.B. DE-A-1 797 373). Diese photopolymerisierbaren Gemische sind mit wäßrigen Lösungsmitteln, insbesondere reinem Wasser, entwickelbar.

An die photopolymerisierbaren Resistmaterialien werden - neben der Entwickelbarkeit mit wäßrig-alkalischen Medien - eine Reihe weiterer, verschiedenartiger Anforderungen gestellt. So müssen die photopolymerisierbaren Mischungen gute Filmbildungseigenschaften aufweisen und sich zu festen, vorzugsweise nicht klebrigen Schichten verarbeiten lassen. Die Resistschichten der Photoresistfilme müssen sich auf Substrate auflaminieren lassen und gute Haftung gegenüber diesen Substraten aufweisen. Dabei ist eine gute Haftungsdifferenzierung sowohl zwischen photopolymerisierbarer Resistschicht und Deckfolie einerseits und photopolymerisierbarer Resistschicht und temporärem Träger andererseits als auch zwischen photopolymerisierbarer Resistschicht und temporärem Träger einerseits und photopolymerisierbarer Resistschicht und Substrat andererseits notwendig. Ferner werden kurze Belichtungs- und Entwicklungszeiten gefordert bei gleichzeitig guter Differenzierung zwischen belichteten und unbelichteten Bereichen und Ausbildung exakter und scharfer Konturen der Resistmuster. Die entwickelten Resistmuster müssen darüber hinaus gute mechanische Eigenschaften besitzen und gegenüber den Chemikalien, wie sie bei der Weiterverarbeitung zur Anwendung kommen, insbesondere Ätz- und Galvanisierbädern, beständig sein.

In der DE-A-27 36 058 wird ein Trockenfilmresist beschrieben, der ohne Zusatz von organischen Stoffen rein wäßrig-alkalisch entwickelbar ist und gleichzeitig im belichteten Zustand eine gute chemische Beständigkeit aufweisen soll. Die photopolymerisierbare Resistschicht dieses Trockenfilmresists enthält ein carboxylgruppenhaltiges, wasserunlösliches Copolymerisat als Bindemittel, ein polares, hydroxylgruppenhaltiges Oligomeres, welches durhc Anlagerung einer Mono- oder Dicarbonsäure, wie z.B. (Meth)acrylsäure, Maleinsäure oder Fumarsäure, an ein Epoxidharz enthalten worden ist, sowie ein polyfunktionelles (Meth)acrylat-Monomeres im Gewichtsverhältnis polymeres Bindemittel zu Oligomer zu Monomer von 1 : 0,15-1 : 0,15-1. Dieser Trockenfilmresist ist hinsichtlich seiner anwendungstechnischen Eigenschaften nicht zufriedenstellend.

In der EP 0 186 091 werden Mischungen aus mindestens 40 Gew.% eines Oligomeren mit einem Molekulargewicht unter 10 000 und bis zu 35 Gew.%, insbesondere aber 10 bis 30 Gew.% eines mit dem Oligomeren verträglichen Polymeren mit einem mittleren Gewichtsmittel größer als 15 000 beschrieben, wobei diese Polymere Homo- und Copolymerisate von N-Vinyllactamen sein können. Die damit erzeugten Resiste sind infolge des hohen Anteils an oligomerem Material homogen und transparent, für die Praxis wegen ungenügender Prozeßstabilität und Lagerfähigkeit der Resiste jedoch ungeeignet.

Insbesondere die Lagerung der unbelichteten Trockenresistfilme unter normalen klimatischen Verhältnissen ist ein immer wiederkehrender Grund zur Reklamation. Die Resistmatrices weisen bei wäßrig-alkalischer Entwicklungsmöglichkeit einen von der relativen Luftfeuchte abhängigen kalten Fluß auf, der
- innerhalb des Resistfilmes zur Strukturausbildung, sogenannten Verprägungen, und
- am Rand des Filmes zum Austreten von Resistmaterial (englischer Fachausdruck: edge fusion)
führt. Insgesamt werden diese Erscheinungen in der Fachwelt unter "ungenügender Rollenstabilität" diskutiert.

In der EP-A-0 233 623 (US 4 686 171) werden Resiste beansprucht, die eine verbesserte Rollenstabilität durch den Zusatz von festen, sowohl in der Polymermatrix als auch im Entwicklermedium unlöslichen anorganischen Oxiden mit Partikeldurchmessern unter 0,02 μm aufweisen; von besonderem Vorteil sind hier spezielle Siliciumdioxide z.B. pyrogene Kieselsäure. In der Praxis führen diese Feststoffpartikel zu einer starken Erosion von metallischen Elementen, wie Rohren und Düsen in den Verarbeitungsgeräten, so daß weiterhin der Wunsch nach Resisten mit verbesserter Rollenstabilität ohne ungünstige Nebenwirkungen besteht.

Die Aufgabe der vorliegenden Erfindung liegt in der Schaffung eines neuen, verbesserten Trockenfilmresists mit einer wäßrig-alkalisch entwickelbaren photopolymerisierbaren Resistschicht, der gute verarbeitungs- und anwendungstechnische Eigenschaften aufweist und mit dem nach den an sich bekannten Verfahren auf einem Substrat Resistmuster hoher Qualität hergestellt werden können und der insbesondere eine gute Rollenstabilität auch bei langer Lagerung des Trockenfilmresists besitzt.

Es wurde nun gefunden, daß diese Aufgabe durch Trockenfilmresists mit einem temporären Träger, einer photopolymerisierbaren, wäßrig-alkalisch entwickelbaren Resistschicht sowie gegebenenfalls einer abziehbaren Deckfolie gelöst wird, bei denen die photopolymerisierbare Resistschicht aus einer homogenen, nur organisches Material enthaltenden photopolymerisierbaren Mischung besteht, die spezielle polymere Bindemittel, verträgliche photopolymerisierbare Monomere, Photoinitiatoren sowie gegebenenfalls weitere Zusatz- und/oder Hilfsmittel in einem zahlenmäßig bestimmten Verhältnis zueinander enthält, wenn man bestimmte Amidgruppen enthaltende polymere Stoffe zusetzt. Dadurch wird eine wesentliche Verbesserung der Rollenstabilität erreicht. Überraschend ist, daß schon ein gewichtsmäßiger Anteil von ≤ 6 Gew.% dieser Amidgruppen enthaltenden Polymere für die erfindungsgemäße Wirkung ausreicht.

Gegenstand der vorliegenden Erfindung ist ein lichtempfindliches, zur Herstellung von Druckformen oder Resistmustern geeignetes Aufzeichnungselement mit einer auf einem dimensionsstabilen Träger aufgebrachten, wäßrig-alkalisch entwickelbaren, ein polymeres Bindemittel, mindestens eine ethylenisch ungesättigte, photopolymerisierbare Verbindung, mindestens einen Photoinitiator sowie gegebenenfalls weitere Zusatz- und/oder Hilfsstoffe enthaltenden, photopolymerisierbaren Aufzeichnungsschicht, das dadurch gekennzeichnet ist, daß in der photopolymerisierbaren Aufzeichnungsschicht ein Zusatz von 0,2 bis 6 Gew.%, bezogen auf die Gesamtmenge der photopolymerisierbaren Aufzeichnungsschicht, eines N-Vinylamid-Homopolymerisats, eines N-Vinyllactam-Copolymerisats, das mindestens 50 Mol% N-Vinyllactam-Einheiten einpolymerisiert enthält, oder eines Polyamids mit Molekulargewichten $\overline{M}_n$ zwischen 1500 und 300 000 g/Mol vorhanden ist.

Als N-Vinylamid-Homopolymerisate sind vorzugsweise N-Vinyllactame, wie N-Vinylpyrrolidon oder N-Vinylcaprolactam, als N-Vinyllactam-Copolymerisate Copolymerisate aus N-Vinylpyrrolidon und einem Vinylester einer Carbonsäure mit 2 bis 18 Kohlenstoffatomen oder ein Copolymerisat aus N-Vinylcaprolactam und einem Vinylester einer Carbonsäure mit 2 bis 12 Kohlenstoffatomen geeignet.

Gegenstand der Erfindung ist insbesondere ein Trockenfilmresist mit einem temporären, dimensionsstabilen Schichtträger, einer auf dem temporären Schichtträger aufgebrachten, festen, unter Anwendung von Druck sowie gegebenenfalls Wärme auf ein Substrat übertragbaren, in wäßrig-alkalischen Entwicklermedien löslichen oder zumindest dispergierbaren, photopolymerisierbaren Resistschicht, sowie gegebenenfalls einer abziehbaren Deckfolie auf der photopolymerisierbaren Resistschicht, welcher dadurch gekennzeichnet ist, daß die photopolymerisierbare Resistschicht gebildet wird aus einer homogenen Mischung von

a) 35 bis 90, vorzugsweise 50 bis 75 Gew.%

mindestens eines in wäßrig-alkalischen Lösungen löslichen oder zumindest dispergierbaren, freie Carboxylgruppen tragenden Bindemittels mit einem mittleren Molekulargewicht $\overline{M}_n$ von 50 000 bis 250 000 g/Mol.

b) 1 bis 55, vorzugsweise 10 bis 35 Gew.% mindestens eines mit dem Bindemittel verträglichen photopolymerisierbaren ethylenisch ungesättigten Monomeren.

c) 0,001 bis 10, insbesondere 0,1 bis 5 Gew.% mindestens eines Photopolymerisationsinitiators.

d) 0,2 bis 6 Gew.% eines N-Vinylamid-Homopolymerisats, vorzugsweise eines Poly[N-vinylpyrrolidons] oder eines Copolymerisats eines N-Vinyllactams mit mindestens 50 Mol% einpolymerisierten N-Vinyllactam-Einheiten mit einem mittleren Molarkulargewicht $\overline{M}_n$ zwischen 1500 und 300 000 g/Mol oder eines Polyamids mit einem mittleren Molekulargewicht zwischen 2000 und 150 000 g/Mol, sowie

e) 0 bis 30, insbesondere 0,05 bis 12 Gew.% an weiteren Zusätzen und/oder Hilfsstoffen, wobei sich die Prozentangaben für die einzelnen Komponenten jeweils auf die gesamte Mischung beziehen.

Gegenstand der Erfindung ist weiterhin ein Verfahren zur Herstellung von Resistmustern auf einem Substrat, bei dem auf das Substrat eine feste, photopolymerisierbare, in wäßrig-alkalischen Entwicklermedien lösliche bzw. dispergierbare Resistschicht aufgebracht, diese Resistschicht bildmäßig im aktinischem Licht belichtet wird und anschließend die nichtbelichteten Bereiche der Resistschicht mit dem Entwicklermedien ausgewaschen werden. Das Verfahren ist dadurch gekennzeichnet, daß die photopolymerisierbare Resistschicht aus einer homogenen, photopolymerisierbaren Mischung, wie vorstehend für die Resistschicht des erfindungsgemäßen Trockenfilmresist angegeben, besteht.

Üblicherweise sind Polymere unterschiedlichen Aufbaus schon in kleinsten Konzentrationen miteinander unverträglich und führen deshalb zu opaken Mischungen, die für photopolymerisierbare Schichten völlig ungeeignet sind. Umso überraschender ist es, daß die erfindungsgemäßen Mischungen miteinander voll verträglich und hochtransparent sind, auch dann, wenn nur das beanspruchte Bindemittel mit dem erfindungsgemäßen Zusatz gemischt und zu einem Film verarbeitet wird. Dies gilt insbesondere für das beanspruchte Mengenverhältnis von 0,2 zu 90 bis 6 zu 35 Gewichtsteilen Zusatz zu Bindemittel

Besonders überraschend und auch für den mit der Materie vertrauten Fachmann nicht vorhersehbar ist der bei der Zumischung der erfindungsgemäßen Zusätze eintretende Verdickungseffekt, d.h. ein starker Viskositätsanstieg sowohl einer Lösung der beanspruchten Mischung als auch der Mischung selbst. So steigt bei Zugabe von 2 Gew.% eines Poly[N-vinylpyrrolidon] mit einem mittleren Molekulargewicht von 50 000 zu einer 50 %igen Lösung eines Acrylatharzes mit 30 Gew.% Methacrylsäure und einem Molekulargewicht von etwa 80 000 so stark an, daß die Mischung geliert.

Damit wird durch den erfindungsgemäßen Zusatz die Rollenstabilität ganz wesentlich verbessert.

Die erfindungsgemäß für die Herstellung der Trockenfilmresist und der Resistmuster einzusetzenden photopolymerisierbaren Resistschichten zeigen im Vergleich zu den bekannten Photoresists eine Reihe vorteilhafter und z.T. überraschender Eigenschaften. Die festen photopolymerisierbaren Resistschichten sind nicht klebrig und lassen sich bei der Verarbeitung gut und ohne besondere Sicherheitsvorkehrungen handhaben. Sie zeigen eine gute Haftungsdifferenzierung; eine bei den Trokenfilmresists gegebenenfalls vorhandene Deckfolie läßt sich problemlos abziehen. Die photopolymerisierbare Resistschicht der erfindungsgemäßen Trockenfilmresists ist sehr gut laminierbar und läßt sich einfach auf Substrate, wie sie als Untergrund für die Herstellung der Resistmuster dienen, insbesondere Metalle, metallische oder metalloxidische Oberflächen, übertragen. Die erfindungsgemäße Resistschicht zeigt dabei nach der Übertragung sowohl im unbelichteten als auch im belichteten Zustand eine sehr gute Haftung gegenüber dem Substrat.

Der temporäre Träger der Trockenfilmresists läßt sich nach dem Auflaminieren bzw. Aufkaschieren der Resistschicht auf das Substrat ohne weiteres von dieser, vorteilhafterweise vor der bildmäßigen Belichtung abziehen. Die erfindungsgemäßen photopolymerisierbaren Resistschichten besitzen sehr gute Belichtungseigenschaften, ein hohes Auflösungsvermögen und ermöglichen bei kurzer Entwicklungsdauer mit wäßrig-alkalischen Entwicklerlösungen eine sehr gute und exakte Differenzierung zwischen belichteten und unbelichteten Bereichen, so daß auch Resistmuster mit feinen Bildelementen korrekt und vorlagengetreu hergestellt werden können. Die erfindungsgemäß hergestellten Resistmuster haben eine hohe mechanische Beständigkeit und sind trotz ihrer wäßrigen Entwickelbarkeit gegenüber den üblicherweise verwendeten sauren Ätz- und Galvanikbädern stabil und besitzen zum Teil auch zusätzlich eine gute Stabilität in ammoniakalischen Ätzbädern.

Insbesondere sind die Resiste auch bei langer Lagerung unter normalen Umweltbedingungen frei von Verprägungen, Strukturen und Kratern in der Schicht und weisen auf beiden Rollenseiten eines Wickels mit 137 m Resist kein ausgelaufenes Material auf. Sie besitzen damit eine gute Rollenstabilität.

Die photopolymerisierbare Resistschicht wird erfindungsgemäß aus mindestens einem filmbildenden, in den wäßrigen-alkalischen Entwicklerlösungen löslichen oder zumindest dispergierbaren Polymeren (Komponente a), mindestens einem photopolymerisierbaren Monomeren (Komponente b), mindestens einem Photopolymerisationsinitiator (Komponente c), den erfindungsgemäßen Zusätzen an den oben beschriebenen Amid-Polymeren (Komponente d) sowie gegebenenfalls weiteren Zusatz- und/oder Hilfsstoffen (Komponente e) in den vorstehend angegebenen, bestimmten Mengenverhältnissen zueinander gebildet. Die einzelnen Komponenten, insbesondere (a) bis (c), sind dabei so ausgewählt und aufeinander abgestimmt, daß sie miteinander verträglich sind und daß das für die bildmäßige Belichtung verwendete aktinische Licht in der Resistschicht nicht gestreut wird. Die Dicke der photopolymerisierbaren Resistschicht liegt üblicherweise im Bereich von etwa 15 bis 70 µm; sie kann je nach Anwendungsgebiet des Photoresists jedoch auch darunter oder darüber liegen.

Zu den Aufbaukomponenten der photopolymerisierbaren Aufzeichnungsschicht ist im einzelnen folgendes auszuführen.

a) Als Beispiele für die in den wäßrig-alkalischen Lösungen löslichen oder dispergierbaren Polymeren, die als Komponente a) in Betracht kommen, seien die Copolymerisate des folgenden Typs genannt, die gegebenenfalls weitere Comonomere einpolymerisiert enthalten können: Styrol/Maleinsäureanhydrid-Copolymerisate, Styrol/Maleinsäurehalbester-Copolymerisate, Styrol/Maleinsäureanhydrid/(Meth)acrylsäure-Copolymerisate, (Meth)acrylsäurealkylester/(Meth)-acrylsäure-Copolymerisate, Styrol/(Meth)-acrylsäurealkyl-ester/(Meth)acrylsäure-Copolymerisate und änliche. Ihr Gehalt an einpolymerisiertem carboxylhaltigen Monomeren liegt vorteilhaft über 18, aber unter 36 Gew.%.

Die als Komponente a) der erfindungsgemäßen photopolymerisierbaren Resistschichten einzusetzenden Polymeren können nach den an sich bekannten und üblichen Polymerisationsmethoden hergestellt werden.

b) Neben der Komponente a) enthalten die erfindungsgemäßen photopolymerisierbaren Resistschichten als Komponente b) 1 bis 55 Gew.%, insbesondere 10 bis 35 Gew.%, bezogen auf die die photopolymerisierbare Resistschicht bildende Mischung, mindestens eines photopolymerisierbaren Monomeren. Diese Monomeren, die üblicherweise einen Siedepunkt bei Atmosphärendruck von über 100° C aufweisen, haben im allgemeinen ein Molekulargewicht unter 10 000. Die photopolymerisierbaren Monomeren, die allein oder in Mischung miteinander eingesetzt werden können, können dabei sowohl mono- als auch polyfunktionell sein, d.h. sie können eine oder mehrere photopolymerisierbare ethylenische Doppelbindungen besitzen. Vorteilhafterweise sind in den erfindungsgemäßen photopolymerisierbaren Resistschicht als Komponente b) Monomere mit zwei oder mehr photopolymerisierbaren ethylenischen Doppelbindungen enthalten. Diese bi- oder mehrfunktionellen Monomeren können dabei allein, in Mischung miteinander oder in Mischung mit monofunktionellen Monomeren, d.h. Monomeren mit nur einer photopolymerisierbaren ethylenischen Doppelbindung, eingesetzt werden. Vorzugsweise kommen solche Monomeren zur Anwendung, die mindestens eine endständige Vinyl- oder Vinyliden-Doppelbindung aufweisen, und insbesondere solche, bei denen die photopolymerisierbare Doppelbindung bzw. die photopolymerisierbaren Doppelbindungen durch Konjugation oder durch Nachbarschaftsstellung zu O-, N- oder S-Atomen aktiviert sind.

Als Vertreter für die photopolymerisierbaren Monomeren seien neben den Allylverbindungen, wie z.B. Allylacrylat und Diallylphthalat und Vinylverbindungen, wie z.B. N-Vinyllactamen und insbesondere N-Vinylpyrrolidon oder N-Vinylcaprolactam, vornehmlich die Acryloyl- und/oder Methacryloyl-Gruppen enthaltenden Monomeren genannt. Hierzu gehören insbesondere die Ester die Acrylsäure und Methacrylsäure, wie z.B. die Di- und Tri(meth)acrylate etwa von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit; Pentaerythrittetra-(meth)acrylat, Glukosetetra-(meth)acrylat; Urethanacrylate und -methacrylate mit 2 oder mehr Acryloyl- bzw. Methacryloyl-Gruppen, wie sie beispielsweise durch Umsetzung von aliphatischen Diolen oder Polyolen der vorstehend genannten Art mit organischen Diisocyanaten, z.B. Hexamethylendiisocyanat, im Äquivalentverhältnis OH:NCO von etwa 1:2 und anschließende Umsetzung der freien Isocyanatgruppen mit Monohydroxy(meth)acrylaten, insbesondere Hydroxyalkyl-(meth)acrylaten hergestellt werden können; Methacrylsäureester mit zwei oder mehr Acryloyl- und/oder Methacrylol-Gruppen, wie sie durch Umsetzung von Acrylsäure und/oder Methacrylsäure mit Di- oder Polyglycidylverbindungen, insbesondere Di- oder Polyglycidylethern, erhalten werden können, wie z.B. das Umsetzungsprodukt aus 2 Mol Acrylsäure und/oder Methacrylsäure mit einem Mol Bisphenol A-bis-glycidylether. Als Beispiel für monofunktionelle Monomere seien die Monoacrylate und Monomethacrylate von Monoalkanolen, insbesondere mit 1 bis 20 C-Atomen, oder der oben genannten Diole und Polyole erwähnt. Zu den besonders bevorzugten Monomeren gehören unter anderem Trimethylolpropantriacrylat, Trimethylolpropantrimethacrylat, Pentaerythrittri- und tetraacrylat sowie Pentaerythrittri- und tetramethacrylat.

c) Als Komponente c) ist in der erfindungsgemäßen photopolymerisierbaren Resistschicht mindestens ein Photopolymerisationsinitiator enthalten. Hierfür kommen insbesondere die für die Herstellung von photopolymerisierbaren Resistschichten bekannten und üblichen Photoinitiatoren bzw. Photoinitiatorsysteme in Betracht. Dazu gehören Benzoin und Benzoinderivate, wie Benzoinether; substituierte Benzoine uns substituierte Benzoinderivate, z.B. substituierte Benzoinether; Benzile, insbesondere Benzilketale, wie z.B. Benzyldimethylketal, Benzilmethylethylketal oder Benzilmethylbenzylketal; und die als Photoinitiatoren bekannten und wirksamen Benzoyldiarylphosphinoxide. Besonders vorteilhaft als Photopolymerisationsinitiator sind Verbindungen vom Typ des Benzophenons und seiner Derivate, wie Benzophenon, 4,4'-Dimethylaminobenzophenon, Thioxanthon und seine Derivate, 4,4'-Diethylaminobenzophenon, Derivate von Michler's Keton, 4,4'-Dichlorbenzophenon etc., sowie deren Gemische, insbesondere Mischungen aus Benzophenon und Michler's Keton; Hexaarylbisimidazole, wie z.B. 2,2'-o-Chlorphenyl-4,4',5,5'-p-methoxyphenyl-bisimidazol, oder Gemische aus Hexaarylbisimidazolen mit Sensibilisierungsmitteln, wie z.B. 2-Mercaptobenzochinazol; mehrkernige unsubstituierte oder substituierte Chinone, wie Anthrachinon, Benzanthrachinon, 2-Ethylanthrachinon oder tert.-Butylanthrachinon; sowie die als Photoinitiatoren wirksamen Acriden- oder Phenacin-Derivate. Typische Beispiele für Photoinitiatorsysteme sind Kombinationen aus Benzophenon oder Benzophenon-Derivaten mit tertiären Aminen, wie Triethanolamin oder Michler's Keton, oder Gemische aus Hexaarylbisimidazolen und Triphenylmethan-Leukofarbstoffen, wie z.B. Leukokristallviolett, Leukomalachitgrün oder Tris-(4-diethylamino-2-methylphenyl)-methan. Die Auswahl der geeigneten Photoinitiatoren bzw. Photoinitiator-Systeme ist dem Fachmann geläufig. Die Photoinitiatoren können allein oder in Mischung miteinander eingesetzt werden und sind in der erfindungsgemäßen photopolymerisierbaren Resistschicht in Mengen von 0,001 bis 10 Gew.%, insbesondere in Mengen von 0,1 bis 5 Gew.%, bezogen auf die photopolymerisierbare Resistschicht, enthalten. Neben den Komponenten a) bis d) können in den erfindungsgemäßen photopolymerisierbaren Resistschicht gegebenenfalls als Komponente e), weitere, die verarbeitungs- und/oder anwendungstechnischen Eigenschaften der Resistschicht verbessernde und/oder modifizierende Zusatz- und/oder Hilfsstoffe enthalten sein. Hierzu gehören, u.a. thermische Polymerisationsinhibitoren, wie z.B. Hydrochinon, Hydrochinon-Derivate, 2,6-Di-tert.-butyl-p-kresol, Nitrophenole, N-Nitrosoamine, wie N-Nitrosodiphenylamin oder die Salze des N-Nitrosocyclohexylhydroxylamins; Farbstoffe und/oder Pigmente, die sowohl als Kontrastmittel als auch schichtverfestigend wirken können, wie z.B. Brilliant Green Dye (C.I. 42 040) Viktoriareinblau FGA, Viktoria-Reinblau 80 (C.I. 42 595), Viktoria-Blau B (C.I. 44 045), Rhodamin 6G (C.I. 45 160), 3-Phenyl-7-dimethylamino-2,2-spiro-di-(2H-1-benzopyran); photochrome Verbindungen oder photochrome Systeme, die unter dem Einfluß von aktinischem Licht ihre Farbe reversibel oder irreversibel ändern, wie z.B. die Leukobasen der Triarylmethan-Farbstoffe, etwa Malachitgrün-Leukobase, Sicomet® Patentblau 80E 131 oder Kristallviolett-Leukobase, oder auch Rhodamin B-Base zusammen mit einem geeigneten Aktivator, z.B. einer organischen unter dem Einfluß von aktinischem Licht Halogen-Radikale abspaltenden Verbindung oder Hexaaryl-bisimidazolen. Weiterhin können in der photopolymerisierbaren Resistschicht sensitometrische Regler enthalten sein, wie z.B. 9-Nitroanthracen, 10,10'-Bisanthrone, Phenazinium-, Phenoxazinium-, Acridinium- oder Phenonthiazinium-Farbstoffe, insbesondere in Kombination mit milden Reduktionsmitteln, 1,3-Dinitrobenzole und ähnliche, wie Füllstoffe. Verstärkungsmittel oder weitere, die mechanischen Eigenschaften verbessernde Zusatzstoffe. Sofern Weichmacher eingesetzt werden, kommen hierfür beispielsweise die an sich bekannten und verträglichen Weichmacher in Betracht. Die weiteren Zusatz- und/oder Hilfsstoffe (Komponente e) sind in der photopolymerisierbaren Resistschicht in den für diese Verbindungen an sich üblichen, wirksamen Mengen enthalten. Ihr Anteil beträgt dabei insgesamt nicht mehr als 30 Gew.% und liegt vorzugsweise im Bereich von 0,05 bis 12 Gew.%, bezogen auf die photopolymerisierbare Resistschicht.

d) Als erfindungsgemäße Zusätze d) kommen in Betracht:
- Homo- und Copolymerisate von N-Vinylamiden wie z.B. Poly[N-vinylformamid], Poly[N-vinylacetamid], Poly[N-vinyl-N-methylacetamid], Poly[N-vinylpyrrolidon], Poly[N-vinylcaprolactam], N-Vinyllactam-Copolymerisate, die mindestens 50 Mol% N-Vinyllactam-Einheiten einpolymerisiert enthalten, wie N-Vinyllactam-Copolymerisate mit Vinylestern von Carbonsäuren mit 2 bis 18 C-Atomen, wie Vinylacetat oder Vinylpropionat oder mit Acrylsäure oder Methacrylsäure, wie z.B. N-Vinylpyrrolidon/Vinylacetat-Copolymerisate unterschiedlicher Mischungsverhältnisse, N-Vinylamid/(Meth)Acrylsäure-Copolymerisate, aber auch Terpolymerisate von N-Vinylamiden mit üblichen polymerisierbaren Monomeren, und

- Polyamide, die als Kondensationsprodukte aus Aminen und Carbonsäuren zugänglich sind, z.B. aus Hexamethylendiamin und Adipinsäure; die mittleren Molekulargewichte $\overline{M}_n$ liegen vorzugsweise bei 1500 bis 150 000 g/Mol.

Als besonders bevorzugt im Hinblick auf die Erhöhung der Viskosität und damit auf die Verbesserung der Rollenstabilität haben sich Poly[N-Vinylcaprolactam] und Poly[N-Vinylpyrrolidon] mit mittleren Molekulargewichten von etwa 50 000 g/Mol erwiesen.

Die wirksamen Konzentrationen an den erfindungsgemäßen Zusätzen liegen üblicherweise im Bereich von 0,2 bis 6, vorzugsweise aber zwischen 0,5 bis 4 Gew.%.

Die Dicke der photopolymerisierbaren Aufzeichnungsschicht richtet sich bekanntermaßen nach dem Anwendungszweck der lichtempfindlichen Aufzeichnungselemente und kann daher in weiten Grenzen schwanken. Für die Herstellung von Hochdruck- oder Tiefdruckformen liegt die Dicke der photopolymerisierbaren Aufzeichnungsschicht im allgemeinen im Bereich von etwa 100 µm bis zu einigen mm; für die Herstellung von Resistmustern werden üblicherweise Schichtdicken der photopolymerisierbaren Aufzeichnungsschicht im Bereich von etwa 15 bis 70 µm eingestellt.

Als typisches Beispiel für eine sehr vorteilhafte, erfindungsgemäße photopolymerisierbare Resistschicht sei folgende Zusammensetzung genannt:

a) 35 bis 90 Gew.% carboxylgruppenhaltiges Copolymer

b) 1 bis 55 Gew.% mehrfunktionelles Acrylat als Monomer

c) 0,001 bis 10 Gew.% Photoinitiator, wie z.B. Benzophenon/Michlers Keton

d) 0,02 bis 6 Gew.%, vorzugsweise 0,5 bis 4 Gew.% eines N-Vinyllactampolymeren, wie z.B. Poly[N-Vinylcaprolactam]

e) 0 bis 30 Gew.% weitere Zusätze..

Als Träger für die photopolymerisierbaren Aufzeichnungsschichten kommen die für lichtempfindliche Aufzeichnungselemente der in Rede stehenden Art üblichen und an sich bekannten dimensionsstabilen, starren oder vorzugsweise flexiblen Schichtträger in Betracht, wobei die Art des Schichtträgers vom Verwendungszweck der lichtempfindlichen Aufzeichnungselemente mitbestimmt wird. So kommen für die Herstellung von Druckplatten als dimensionsstabile Träger insbesondere Kunststoff-Filme oder Folien, z.B. aus Polyestern, sowie metallische Schichtträger, beispielsweise aus Stahl oder Aluminium, in Betracht. Für Photoresistfilme und Schichtübertragungsmaterialien finden als Trägermaterialien vorzugsweise Kunststoff-Filme oder -Folien, insbesondere Polyester-Folien, Verwendung, die eine mäßige Haftung zu der photopolymerisierbaren Aufzeichnungsschicht haben und nach dem Auflaminieren bzw. Aufkaschieren der photopolymerisierbaren Aufzeichnungsschicht auf ein Substrat von dieser - vor oder nach der Belichtung mit aktinischem Licht - abgezogen werden können. Für die Herstellung von Resistmustern kann die photopolymerisierbare Aufzeichnungsschicht auch direkt auf das zu schützende sowie gegebenenfalls dauerhaft zu modifizierende Substrat aufgebracht werden, welches dann als Träger für die photopolymerisierbare Aufzeichnungsschicht fungiert. Als Substrate für Photoresistschichten kommen beispielsweise Kupferbleche, kupferkaschierte Basismaterialien, Keramiksubstrate, die mit metallischen oder metalloxidischen Schichten beschichtet sind, Halbleiterelement, Silicium-Wafer und dergleichen in Betracht. Die Trägermaterialien für die photopolymerisierbaren Aufzeichnungsschichten können gegebenenfalls in an sich bekannter Weise, z.B. mechanisch, chemisch, elektrochemisch und/oder durch Versehen mit einer Haftgrundierung, vorbehandelt sein. Gleichermaßen können zwischen photopolymerisierbarer Aufzeichnungsschicht und Träger auch noch einer oder mehrere Zwischenschichten angeordnet sein. Bei lichtempfindlichen Aufzeichnungselementen für die Herstellung von Druckformen, insbesondere Hochdruck- oder Tiefdruckformen, können diese Zwischenschichten als Haftschicht und/oder Lichthofschutzschicht ausgebildet sein. Bei Photoresistfilmen und Schichtübertragungsmaterialien kann eine solche Zwischenschicht zwischen photopolymerisierbarer Aufzeichnungsschicht und dem abziehbaren, temporären Schichtträger das Abziehen des Schichtträgers nach dem Auflaminieren bzw. Aufkaschieren der photopolymerisierbaren Aufzeichnungsschicht auf das Substrat erleichtern und/oder als Sauerstoffsperrschicht nach dem Abziehen des Schichtträgers dienen.

Ebenso kann auf der dem Träger abgewandten Oberfläche der photopolymerisierbaren Aufzeichnungsschicht auch noch eine Deckschicht oder Deckfolie angeordnet sein, die vorzugsweise in dem gleichen Entwickler-Lösungsmittel löslich ist wie die photopolymerisierbare Aufzeichnungsschicht, oder von dieser abziehbar ist. Diese Deckschicht bzw. Deckfolie dient vor allem dem Schutz der photopolymerisierbaren Aufzeichnungsschicht bei der Lagerung und Handhabung der lichtempfindlichen Aufzeichnungselemente und gegebenenfalls auch als Sauerstoffsperre für die photopolymerisierbare Aufzeichnungsschicht. Als besonders geeignet haben sich z.B. Deckschichten aus Polyvinylalkoholen oder Polyvinylalkohol-Derivaten bzw. - insbesondere bei Photoresistfilmen - Deckfolien aus Polyolefinen, wie z.B. Polyethylen oder Polypropylen erwiesen.

Die Herstellung der erfindungsgemäßen lichtempfindlichen Aufzeichnungselemente kann in an sich bekannter und üblicher Weise durch Herstellung einer homogenen Mischung der die photopolymerisierbare Aufzeichnungsschicht bildenden Komponenten und schichtförmiges Aufbringen dieser Mischung auf den - gegebenenfalls mit einer Zwischenschicht versehenen - Träger erfolgen. Beispielsweise kann man die Komponenten der photopolymerisierbaren Aufzeichnungsschicht rein mechanisch in einer geeigneten Mischvorrichtung, z.B. einem Mischer oder Extruder, homogen vermischen und diese Mischung, beispielsweise durch Extrudieren, Kalandrieren oder Pressen, zu einer Schicht der gewünschten Dicke formen, die dann auf den Träger auflaminiert bzw. aufkaschiert wird. Vorteilhafterweise werden die lichtempfindlichen Aufzeichnungselemente jedoch hergestellt, indem man die Komponenten der photopolymerisierbaren Aufzeichnungsschicht in einem geeigneten Lösungsmittel oder Lösungsmittelgemisch löst und diese Lösung durch Gießen, Tauchen, Sprühen oder anderen bekannte Auftragstechniken in der gewünschten Schichtstärke auf den Träger aufbringt. Anschließend wird das Lösungsmittel in üblicher Weise entfernt und die photopolymerisierbare Aufzeichnungsschicht getrocknet. Geeignete Lösungsmittel für das Mischen der Komponenten und Aufbringen der photopolymerisierbaren Aufzeichnungsschicht auf den Träger sind u.a. niedere Alkohole, Ketone oder Ester, wie z.B. Methanol, Aceton, Methylethylketon, Ethylacetat und ähnliche, sowie Mischungen hiervon. Anschließend kann auf die photopolymerisierbare Aufzeichnungsschicht gewünschtenfalls noch die Deckschicht oder Deckfolie aufgebracht werden.

Die erfindungsgemäßen lichtempfindlichen Aufzeichnungselemente eignen sich in vorteilhafter Weise für die Herstellung von Druckformen oder Resistmustern nach den hierfür an sich bekannten und üblichen Verfahren. Hierzu wird die photopolymerisierbare Aufzeichnungsschicht - bei Photoresistfilmen und Schichtübertragungsmaterialien nach der Schichtübertragung auf das zu schützende Substrat - bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein.

Durch die bildmäßige Belichtung mit dem aktinischem Licht wird in den belichteten Bereichen der Aufzeichnungsschicht eine Photopolymerisation ausgelöst, die zu einer Vernetzung in den belichteten Schichtbereichen und damit zu einer Löslichkeitsdifferenzierung zwischen den belichteten und unbelichteten Schichtbereichen führt. Nach der bildmäßigen Belichtung wird die Druckform bzw. das Resitmuster durch Auswaschen der unbelichteten, unvernetzten Bereiche der Aufzeichnungsschicht mit einer wäßrig-alkalischen Entwicklerlösung entwickelt. Das Enwickeln kann durch Waschen, Sprühen, Reiben, Bürsten etc. erfolgen. Die erfindungsgemäßen Aufzeichnungselemente zeigen dabei einen großen Entwicklungsspielraum und eine sehr geringe Überwaschempfindlichkeit. Als Entwicklerlösungen kommen wäßrig-alkalische Lösungen in Betracht, die zur Einstellung des günstigen pH-Wertes, im allgemeinen im Bereich von 8 bis 14, vorzugsweise im Bereich von etwa 9 bis 11, alkalisch reagierende Substanzen, wie z.B. Borax, Dinatriumhydrogenphosphat, Soda, Alkalihydroxide oder organische Basen, wie Di- oder Triethanolamin in Wasser gelöst, enthalten. Die wäßrig-alkalischen Entwicklerlösungen können auch Puffersalze, z.B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z.B. Natriumcarboxymethylcellulose, Polyvinylalkoyhol, Polynatriumacrylat und dergleichen, mitverwendet werden. Obwohl die erfindungsgemäßen Aufzeichnungselemente im allgemeinen mit rein wäßrig-alkalischen Entwicklerlösungen ausgewaschen werden, ist es selbstverständlich grundsätzlich möglich, wenn auch nicht erforderlich, daß die wäßrig-alkalischen Entwicklerlösungen auch noch geringe Zusätze an wasserlöslichen organischen Lösungsmitteln, wie z.B. aliphatischen Alkoholen, Aceton oder Tetrahydrofuran, enthalten.

Die Erfindung wird durch die nachfolgenden Beispiele näher erläutert. Die in den Beispielen genannten Teile und Prozente beziehen sich, sofern nicht anders angegeben, auf das Gewicht.

Beispiel 1

Aus folgenden Komponenten wurde eine 46,5 %ige, homogene Lösung in einem Gemisch aus 50 Vol% Methanol und 50 Vol% Methylethylketon hergestellt:

62 Gew.% eines Copolymerisats mit 40 Gew.% Styrol, 25 Gew.% Ethylacrylat, 25 Gew.% Methacrylsäure und 10 Gew.% Methylmethacrylat mit einem mittleren Molekulargewicht $\overline{M}_n$ von etwa 105 000

13 Gew.% Tripropylenglykoldiacrylat

11 Gew.% Trimethylolpropantriacrylat

5 Gew.% N-Butylbenzosulfonamid

2 Gew.% Poly[N-vinylpyrrolidon], $\overline{M}_n$ ca. 33 000
1 Gew.% Kristallviolettleucobase
3 Gew.% 2,5-Dichlor-1,4-bis(dichlormethyl)benzol
3,6 Gew.% Benzophenon
0,2 Gew.% Michler's Keton
0,05 Gew.% Sicomet Patentblau 80 E 131
0,15 Gew.% Di-t-butyl-p-kresol

Die filtrierte Lösung wurde zur Herstellung eines Resistmusters in einer solchen Schichtstärke auf ein kupferkaschiertes Basismaterial gegossen, daß nach dem Ablüften des Lösungsmittels und Trocknen eine Trockenschichtdicke von 40 μm resultierte. Zur Herstellung von Leiterbahnen wurde diese photopolymerisierbare Resistschicht bildmäßig mit aktinischem Licht belichtet und die unbelichteten Schichtanteile mit einer 1 %igen wäßrigen Sodalösung ausgewaschen. Es wurde ein gut ausgebildetes Resistmuster erhalten. Die freigelegten Bereiche des Kupfers konnten in üblichen Ätsbädern geätzt werden.

Eine Rolle mit 137 m Resist wurde in einem Klimaschrank mit 27°C und 65 % relativer Feuchte gelagert und jeden Tag hinsichtlich Verprägungen und Auslaufen des Resistmaterials am Rand beobachtet. Erste Verprägungserscheinungen wurden nach 50 Tagen Lagerung registriert. Ein erstes Austreten von Material auf der Rolle wurde in Kernnähe nach 11 Tagen festgestellt. Ein Verkleben der Resistbogen auf dem Wickel über am Rand ausgetretenes Material trat nach 20 Tagen auf.

Vergleichsbeispiel 1

Es wurde wie in Beispiel 1 gearbeitet, jedoch wurde der Zusatz des Poly[N-Vinylpyrrolidons] unterlassen und durch Zusatz der entsprechenden Menge Copolymerisat (Komponente a) ersetzt.

Es wurden Verprägungen schon nach 6 Tagen und ein Auslaufen in Kernnähe nach 2 Tagen registriert.

Bespiel 2

Es wurde wie in Beispiel 1 gearbeitet, jedoch wurde anstelle eines Poly[N-Vinylpyrrolidons] mit einem mittleren Molekulargewicht von etwa 33 000 g/Mol ein solches mit einem mittleren Molgewicht von 50 000 g/Mol eingesetzt. Um eine gleiche Gießviskosität wie in Beispiel 1 zu erhalten, mußte der Feststoffgehalt auf 38 Gew.% reduziert werden.

Beispiel 3

Es wurde wie in Beispiel 1 verfahren, aber ein Poly[N-vinylpyrrolidon] mit einem mittleren Molekulargewicht $\overline{M}_n$ von 240 000 g/Mol eingesetzt. Die Viskosität der Lösung stieg so stark an, daß zur Verarbeitung der Feststoffgehalt von 46,5 auf 23 Gew.% gesenkt werden mußte.

Beispiel 4

Der gleiche Effekt wie in Beispiel 2 wird im Falle des Beispiels 1 erhalten, wenn die Konzentration des Poly[N-vinylpyrrolidons]mit dem mittleren Molekulargewicht von 33 000 g/Mol von 2 auf 4 Gew.% angehoben wird.

Beispiel 5

Es wird wie in Beispiel 1 verfahren, anstelle des Poly[N-vinylpyrrolidons] wird ein Copolymerisat gleichen Molekulargewichts mit 60 Gew.% N-Vinylpyrrolidon und 40 Gew.% Vinylacetat eingesetzt. Verprägungserscheinungen werden nach 20 Tagen, ein Auslaufen am Rande nach 7 Tagen beobachtet.

Beispiel 6

Unter Rühren wurde eine 48%ige homogene Lösung in Aceton/Methanol 1:1 mit folgenden Bestandteilen hergestellt:
64,7 % eines Copolymerisats aus 57 Gew.% Methylmethacrylat, 23 Gew.% Methacrylsäure 20 Gew.% Ethylacrylat mit einem mittleren Molekulargewicht von etwa 85 000
2 % eines Copolymerisats aus 66 % N-Vinylpyrrolidon und 34 % Vinylpropionat
18 % Trimethylolpropantriacrylat
10 % Tetraethylenglykoldimethacrylat
3,5 % Benzophenon
0,15 % Michler's Keton
3 % 2,5-Dichlor-1,4-bis(dichlormethyl)benzol
0,5 % Kristallviolett-Leukobase
0,05 % Sicomet Patentblau 80 E 131
0,1 % Di-t-butyl-p-Kresol

Die Lösung wurde durch ein Druckfilter filtriert und dann in solcher Schichtstärke auf eine 23 μm dicke Polyethylenterephthalat-Folie gegossen, daß nach dem Ablüften der Lösungsmittel und Trocknen (3 Minuten bei 80°C) eine Trockenfilmdicke von 35 μm resultierte. Die photopolymerisierbare Resistschicht wurde bis zur Weiterverarbeitung des so erhaltenen Trockenfilmresists mit einer 23 μm dicken Polyethylen-Folie abgedeckt.

Erste Verprägungen wurden nach 35 Tagen, ein Auslaufen nach 9 Tagen festgestellt.

Vergleichsbeispiel 2

Es wurde wie in Beispiel 6 gearbeitet, das Copolymerisat aus N-Vinylpyrrolidon und Vinylpropionat wurde durch das Bindemittel ersetzt. Verprägungen traten nach 3 Tagen, Resistauslaufen nach einem Tag auf.

**Ansprüche**

1. Lichtempfindliches, zur Herstellung von Druckformen oder Resistmustern geeignetes Aufzeichnungselement mit einer auf einem dimensionsstabilen Träger aufgebrachten wäßrig-alkalisch entwickelbaren, ein polymeres Bindemittel, mindestens eine ethylenisch ungesättigte, photopolymerisierbare Verbindung, mindestens einen Photoinitiator sowie gegebenenfalls weitere Zusatz- und/oder Hilfsstoffe enthaltenden photopolymerisierbaren Aufzeichnungsschicht, dadurch gekennzeichnet, daß in der photopolymerisierbaren Aufzeichnungsschicht ein Zusatz von 0,2 bis 6 Gew.%, bezogen auf die Gesamtmenge der photopolymerisierbaren Aufzeichnungsschicht, eines N-Vinylamid-Homopolymerisats, eines N-Vinylamid-Copolymerisats, das mindestens 50 Mol% N-Vinylamid-Einheiten einpolymerisiert enthält, oder eines Polyamids mit Molekulargewichten $\overline{M}_n$ zwischen 1500 und 300 000 g/Mol vorhanden ist.

2. Lichtempfindliches Aufzeichnungselement nach Anspruch 1, dadurch gekennzeichnet, daß als N-Vinylamid-Homopolymerisat N-Vinylpyrrolidon oder N-Vinylcaprolactam eingesetzt wird.

3. Lichtempfindliches Aufzeichnungselement nach Anspruch 1, dadurch gekennzeichnet, daß als N-Vinylamid-Copolymerisat ein Copolymerisat aus N-Vinylpyrrolidon und einem Vinylester einer Carbonsäure mit 2 bis 18 Kohlenstoffatomen oder ein Copolymerisat aus N-Vinylcaprolactam und einen Vinylester einer Carbonsäure mit 2 bis 12 Kohlenstoffatomen eingesetzt wird.

4. Lichtempfindliches Aufzeichnungselement nach Anspruch 1, dadurch gekenzeichnet, daß als Polyamid ein Polykondensationsprodukt aus Hexamethylendiamin und Adipinsäure eingesetzt wird.

5. Lichtempfindliches Aufzeichnungselement nach einem der vorhergehenden Ansprüche, dadurch gekennzeichnet, daß als polymeres Bindemittel ein Carboxylgruppen enthaltendes filmbildendes Copolymerisat eingesetzt wird, das in Wasser unlöslich, in wäßrig-alkalischen Lösungen jedoch löslich oder dispergierbar ist.

6. Lichtempfindliches Aufzeichnungselement nach einem der vorhergehenden Ansprüche, dadurch gekennzeichnet, daß die photopolymerisierbare Aufzeichnungsschicht einen Inhibitor gegen die thermische Polymerisation enthält.

7. Trockenfilmresist einem temporären, dimensionsstabilen Schichtträger, einer auf dem temporären Schichtträger aufgebrachten festen, unter Anwendung von Druck sowie gegebenenfalls Wärme auf ein Substrat übertragbaren, in wäßrig-alkalischen Entwicklermedien löslichen oder zumindest dispergierbaren, photopolymerisierbaren Resistschicht sowie gegebenenfalls einer abziehbaren Deckfolie auf der photopolymerisierbaren Resistschicht, dadurch gekennzeichnet, daß als photopolymerisierbare Resistschicht eine photopolymerisierbare Aufzeichnungsschicht gemäß einem der vorhergehenden Ansprüche eingesetzt wird.

8. Trockenfilmresist nach Anspruch 7, dadurch gekennzeichnet, daß die photopolymerisierbare Resistschicht gebildet wird aus einer homogenen Mischung von

a) 35 bis 90 Gew.% mindestens eines in wäßrig-alkalischen Lösungen löslichen oder zumindest dispergierbaren, freie Carboxylgruppen tragenden Bindemittels mit einem mittleren Molekulargewicht $\overline{M}_n$ von 30 000 bis 250 000 g/Mol,
b) 1 bis 55 Gew.% mindestens eines mit dem Bindemittel verträglichen photopolymerisierbaren ethylenisch ungesättigten Monomeren,
c) 0,001 bis 10 Gew.% mindestens eines Photopolymerisationsinitiators,
d) 0,2 bis 6 Gew.% eines N-Vinylamid-Homopolymerisats, eines N-Vinylamid-Copolymerisats, das mindestens 50 Mol% N-Vinylamid-Einheiten einpolymerisiert enthält, oder eines Polyamids mit Molekulargewichten $\overline{M}_n$ zwischen 1500 und 300 000 g/Mol
sowie
e) 0 bis 30 Gew.% an weiteren Zusatz- und/oder Hilfsstoffen,
wobei sich die Gewichtsprozente jeweils auf die Gesamtmenge der photopolymerisierbaren Resistschicht beziehen.

9. Verfahren zur Herstellung von Resistmustern auf einem Substrat, bei dem auf das Substrat eine feste, photopolymerisierbare, in wäßrig-alkalischen Entwicklerlösungsmitteln lösliche bzw. dispergierbare Resistschicht aufgebracht ist, diese Resistschicht bildmäßig mit aktinischem Licht belichtet wird und anschließend die nichtbelichteten Bereiche der Resistschicht mit dem Entwicklerlösungsmittel ausgewaschen werden, dadurch gekennzeichnet, daß eine photopolymerisierbare Resistschicht gemäß Anspruch 8 eingesetzt wird.